# EUROPEAN PATENT APPLICATION

(11) **EP 1 207 426 A1**
(43) Date of publication of application: **22.05.2002**
(21) Application number: 00124947.3
(22) Date of filing: 15.11.2000
(51) Int. Cl.: G03F 9/00, H01L 23/544

(54) **Method for aligning a semiconductor wafer**

(71) Applicant: Semiconductor 300 GmbH & Co. KG, 01099 Dresden (DE)
(72) Inventor: Schedel, Thorsten, 01109 Dresden (DE); Schmidt, Sebastian, 01127 Dresden (DE)
(74) Representative: Fischer, Volker, Dipl.-Ing.

(57) **Abstract**

Alignment marks (1) in X- and Y-direction are measured in different layers of a semiconductor wafer (2) using a different filter (5) or algorithm for each direction measurement as well as a different template signal (4) in order to retrieve displacements to be corrected by an alignment. Thus, separate requirements provided by different layers (10, 11) on a wafer (2) concerning overlay accuracy in different directions can be fulfilled. Shorts or missing contacts in design patterns with small tolerances can be avoided efficiently.

## Description

The present invention relates to a method for aligning a semiconductor wafer, the semiconductor wafer having at least two structured layers, a first structured layer comprising at least one alignment mark for providing a position measurement in a first direction, and a second structured layer comprising at least one alignment mark for providing a position measurement in a second direction being different from the first direction, both directions defining the wafer plane.

In semiconductor wafer manufacturing the relative position of patterns being projected and structured in different layers during consecutive lithographic steps is one of the most critical issues. With decreasing minimum feature sizes on semiconductor wafers it becomes growingly difficult to expose a layer with a mask or reticle pattern having a sufficient overlay accuracy with a corresponding pattern in the layer below, e.g. a contact hole connecting two metal lines in different layers. If such a pattern is not placed correctly the final chip may not work as desired, because the small overlap area results in a too high resistance or there is no contact at all. Thus, it is commonly required that the overlay accuracy during a lithographic step is about one fifth of the corresponding feature size on the chip.

In order to achieve this alignment marks are provided with a mask or reticle and are projected with the pattern onto the wafer. During the subsequent lithographic step these alignment marks are used to determine absolute positions on the wafer, such that the interferometrically determined positions of the wafer stage holding the semiconductor wafer during exposure can be gauged to the wafer coordinates. By moving the wafer stage the semiconductor wafer can be aligned to the projected image of the mask or reticle.

There are several techniques employed to align a semiconductor wafer in a lithographic tool, e.g. a wafer stepper or scanner. One method is to scan the alignment marks with a spot of a laser beam moving across the alignment marks comprising a set of parallel lines or bars, a checkerboard pattern or the like, and then to receive the scattered or diffacted light with a photomultiplier or a photodiode etc. Another method is to illuminate the alignment marks with a preferably monochromatic light, to magnify these images and then to pick up these image signals with a CCD camera. The recorded signal commonly reflects a photoelectric intensity or surface reflectivity as a function of position across the alignment mark. This signal has to be compared, or correlated, with a reference signal, which reveals a gauged position on the wafer surface and the deviation from this reference signal gives an amount of misalignment of the semiconductor wafer, which is to be corrected by said wafer stage movement.

The detection of positions in either x- or y-direction is commonly treated separately using different alignment marks. As an example, the position in x-direction can be measured using a set of four parallel, e.g. 4 µm wide, bars. These bars are orientated in the y-direction and a CCD-camera records several pixel lines perpendicular to these bars, thereby crossing the bars. The photoelectric signal thus obtained will have a wave-like form. After being pre-processed and digitised in an A/D-converter a processing unit performs the correlation of the recorded signal with a template signal, which corresponds to an ideal wave-form. The centers of the waves fitted to the recorded signal give a measure of absolute position.

Various filters can be utilised to process the recorded signal, e.g. a contrast amplification, smoothing the signal or adjusting a slice-level. Also, various template signals for the wave-form can be chosen, which may differ in edge steepness, cut-off values, smoothing length, etc. The exact choice of filter parameters and template signals depends on the quality of the alignment marks or the amount of obscurity and reflectivity of layers covering the alignment mark. When aligning a wafer on a wafer stage one commonly selects alignment marks in the uppermost layers, chooses the processing parameters and the optimal fitting template signals. The position and corrections necessary to reach a high alignment accuracy.

Unfortunately, the requirements for alignment are getting stronger with decreasing minimum feature sizes. E.g., in the case of memory or a logic products, certain layers set strong conditions to a particularly high alignment acuracy in the x-direction, while the same is valid for other layers of the same product in the y-direction. If according to prior art one selects a first alignment mark in the x-direction in one layer and a second alignment mark in the y-direction in another layer the set of chosen filter parameters and template signals to determine position in x- and y-direction retrieve poor fitting results and thus a coarse alignment in at least one the directions.

The reason is, that conditions for the recorded signal resulting from the different layers may not be comparable, or cannot be represented by the same template signal, since alignment marks from different layers suffered different manufacturing process histories and therefore distinct surface and reflectivity characteristics. Therefore the fitting procedure for the position determination becomes inefficient, the alignment accuracy is reduced and the wafer yield in particular in the high-end regime of products will disadvantageously decrease.

It is therefore the primary objective of the present invention to increase the semiconductor wafer yield by improving the alignment accuracy in the lithographic step.

This objective is solved by a method for aligning a semiconductor wafer, the semiconductor wafer having at least two structured layers, a first structured layer comprising at least one alignment mark for providing a position measurement in a first direction, and a second structured layer comprising at least one alignment mark for providing a position measurement in a second direction being different from the first direction, both directions defining the wafer plane, comprising the steps of selecting the first structuring layer and said at least one alignment mark for providing a position measurement in a first direction therein, recording a first photoelectric signal of the alignment mark of the first structured layer as a function of position in said first direction, correlating the first signal with a first template signal and determining the position in said first direction, selecting the second structured layer and said at least one alignment mark for providing a position measurement in a second direction being different from the first direction, recording a photoelectric signal of the alignment mark of the second structured layer as a function of position in said second direction, correlating said second signal with a second template signal and determining the position in said second direction, and adjusting a wafer stage holding the semiconductor wafer in response to the position measurement in both directions.

According to the present invention a method is provided, in which different template signals and, in a further aspect, different sets of filter parameters are used to process and correlate the signal in order to determine the position in the x- and y-direction. The structured layers can be chosen according to the requirements given by the design with respect to the x- or y-direction. E.g., if there is a critical overlay issue in x-direction in one layer, but no such problem in y-direction, and some critical overlay issue in y-direction in another layer, these two structured layers can be selected for the x- and y-direction, respectively, and the processing parameters and template signals can advantageously be chosen individually in order to achieve an optimal alignment accuracy.

Because the photoelectric signals, i.e. the intensity of light scattered or diffracted from lines of pixels or spots across the alignment marks recorded with a CCD-camera, photodiode, or photomultiplier etc. and processed thereafter, differs significantly from layer to layer, the present method can advantagesouly process the recorded signals using different sets of parameters in order to optimize the signal for further processing. In particular, the resolution can be adjusted, the contrast can be amplified and the slice-level be set in order to retrieve a signal, which as far as possible emphasizes the wave-like form according to the alignment structure, which commonly has a periodic pattern, and reduces the amount of influences on the signal, which are due to manufacturing processes being carried out after the projection of the layer comprising the alignment mark under inspection.

This feature becomes more prominent in the case of deeply lying structured layers with respect to the current layer. The same is valid for the template signals with which the processed signal is to be correlated in order to determine the position. The alignment marks in deeper layers can have changed their light scattering characteristics, such that the template signals, which are appropriate for the corresponding alignment mark might differ from those which are appropriate for the upper most layers. Thus, by choosing different sets of parameters for the filters applied to process the signal and different template signals applied to correlate the signal the individual position determination in the respective directions can be chosen so as to give the most accurate overlay quality. Due to this the alignment accuracy during the lithographic step is advantagesouly improved and one is even free to choose the most critical layers for a position determination in x- and y-direction thereby enabling the manufacturer to maintain even tighter alignment and overlay tolerances.

The present method can be applied to any kind of alignment with alignment marks enabling a measurement in two directions. Because the time needed for the calculation of the correlation by the processing system is negligible as compared to the time needed for the measurement, no delay will occur when aligning and exposing a semiconductor wafer. This is valid for step alignment as well as global alignment. Since the separation of the filter processing and the correlating step into steps associated with the x- and y-directions leads to respective alignment accuracy improvements, new input for the establishing of mathematical models concerning the projection and wafer stage correction can be expected. Problems with scaling, orthogonality and wafer or chip magnification can be handled more accurately.

The method according to the present invention can be applied to photoelectric signals, which are maintained, processed and correlated in an analog or digitised way, or are modified using other mechanisms, e.g. optical processing. Also, in a more simple arrangement, the correlation can be performed without processing the recorded photoelectric signals using filters for contrast-level or slice-level adjustment.

In addition to the aspect of correlating the photoelectric signal with the template signal, determining the position and comparing the position with a reference position, which can equally be obtained by recording the signal from a reference mark, the recorded photoelectric signal can also be compared and correlated directly with the reference signal, which is considered in a further aspect. In this case the template signal is to be considered as the reference signal, since the reference mark itself reflects a virtual alignment pattern.

Further advantages and aspects are evident from the dependent claims.

The invention is now described with reference to an embodiment taken in conjunction with the accompanying drawings, wherein
- figure 1: shows schematically simplified pattern structures from three layers in a memory cell illustrating an embodiment of the present invention.
- figure 2: shows a flowchart according to the embodiment of the present invention.
- figure 3: shows an image of an alignment mark according to an embodiment of the present invention overplotted by a recorded photoelectric signal (a), a diagram of a recorded signal wave (b), and a template signal used to correlate the signals in both layers, in both y- (left) and x-direction (right).

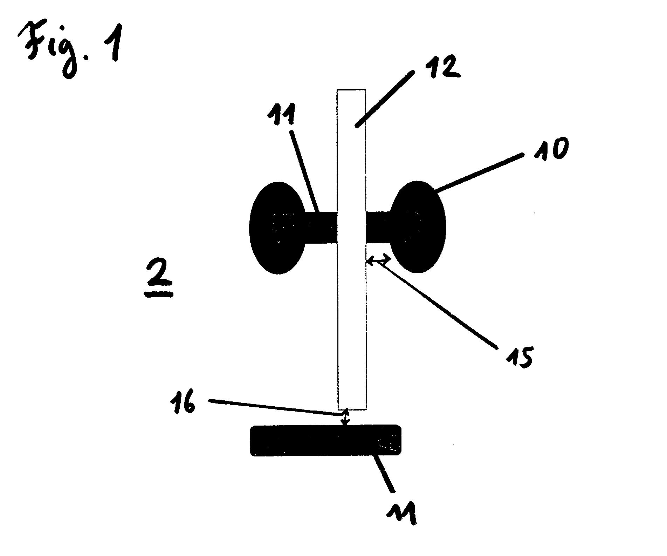

An alignment of a semiconductor wafer 2 comprising memory chips will now be considered as an embodiment. Two structured layers 10, 11 of the wafer 2 shown in figure 1 have already been formed, while a third layer 12 is currently to be patterned in the lithographic tool. In a first layer the egg-like forms of deep trenches 10 for forming the capacitors of the memory cells have been structured, while in a second layer active areals 11 for forming the transistors are patterned. This is followed by a third layer keeping the gate contacts 12, or the word lines, controlling the transistor. With the rapid decrease of minimum feature sizes especially in the area of memory products it becomes clear that the gate contact 12, when being structured in a lithographic step, has to keep a high alignment accuracy in x-direction in order to avoid a short with the deep trench 10, both having a distance of a critical dimension 15 between them.

But the same layer, gate contact 12, has to maintain a high alignment accuracy with respect to an active area structure 11 at the memory cell boundary in y-direction, both structures having to keep a critical dimension 16 between them. Thus, when structuring the gate contact layer 12 the wafer 2 will be aligned according to the present invention in x-direction with respect to the deep trench structuring layer 10 and in y-direction with respect to the active area structuring layer 11.

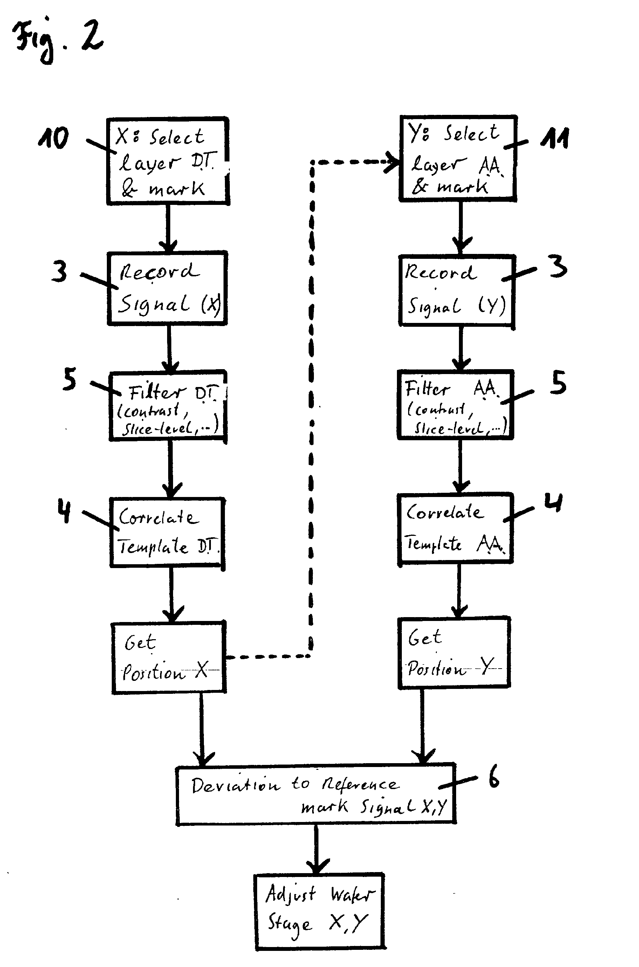

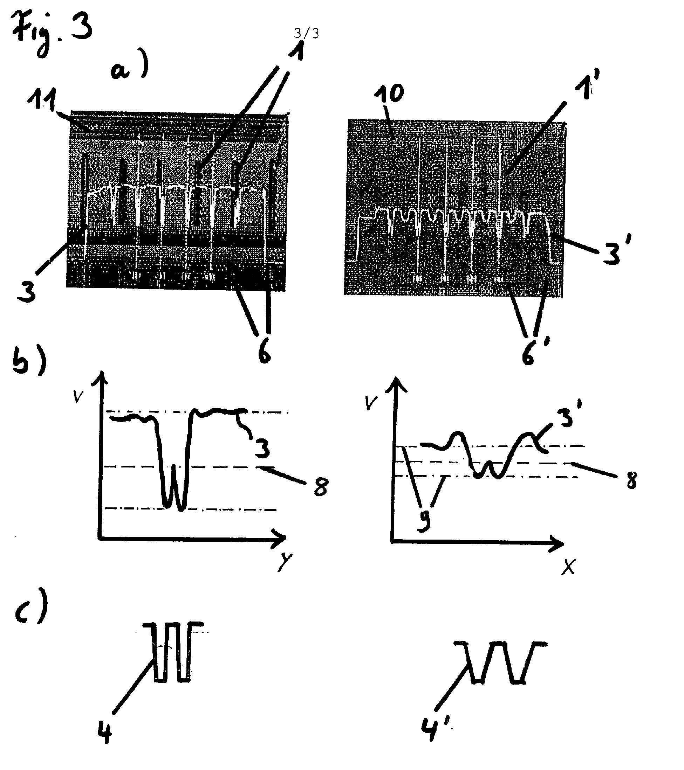

The steps for adjusting the wafer stage taken are shown in figure 2. A Canon excimer-stepper is used to perform the lithographic step. The layer currently to be structured is the gate contact layer 12. An x-direction alignment mark 1' in the deep trench layer 10 is chosen to be measured and the position window is signalled to the alignment optics. A CCD-camera in the off-axis-alignment system takes the image of the window containing the alignment mark 1' and a one-dimensional wave-form signal 3' is formed by integrating the digitized photoelectric counts in narrow lines perpendicular to the alignment mark bars. The layout used for the alignment marks 1, 1' according to this embodiment are visible from figure 3a. It consists of four inner bars and two outer bars. In the same image the recorded signal 3' is overplotted, and the edges of the alignment mark bars can be seen as deep notches across the photoelectric signal 3'. As can be seen from a schematic representation of one wave-packet in figure 3b the recorded photoelectric signal 3' can be processed through filter 5' in which the contrast 9 can be altered and a slice-level 8 can be set. Afterwards an appropriate template signal 4', as it is visible in figure 3c, can be chosen, or can be provided by finding a best fit, and is used to correlate with a photoelectric signal 3' already being processed. The correlation gives a best fit of the individual wave-form center positions visible as the vertical lines in figure 3a. The centers of gravity of these 4 positions can serve as an absolute position determination for the alignment mark 1 in x-direction.

The same procedure can be provided for the comparison with a reference mark 6, 6' being coarsely visible in the bottom region of both figures 3a, which is projected, e.g., through the reticle onto a defined position besides align marks 1, 1'. The deviations between both determined absolute positions are used as input into mathematical algorithms determining, e.g., linear drifts of the setpped exposure fields across the semiconductor wafer 2. According to these models the amount of misalignment can be corrected by moving the wafer stage correspondingly.

The same procedure is then repeated for the active area structuring layer 11 considering the y-direction. As is visible from figure 3 the filter 5 parameters for processing the recorded photoelectric signal 3 significantly differ between the active area structuring layer 11 (left side) and the deep trench structuring layer 10 (right side). Since the deep trench structuring layer 10 is already buried deeper below the current wafer surface and has suffered numerously more structuring processes like CMP (chemical mechanical polishing) the notches are broadened and the signal intensity has reduced.

Therefore, the best fit template signal 4 for the photoelectric signal 3 differs from the template signal 4' being used for the correlation of the photoelectric signal 3' of the active area structuring layer 11. Thus, although having a significantly poor quality, an accurate alignment position determination is achieved for the x-direction as well as for the more evident y-direction, and the respective critical dimensions 15, 16 in x and y are satisfactorily maintained by the method according to the present invention.

## Claims

1. Method for aligning a semiconductor wafer (2) in an exposure tool, the semiconductor wafer (2) having at least two structured layers (10, 11), a first structured layer (10) comprising at least one alignment mark (1) for providing a position measurement in a first direction, and a second structured layer (11) comprising at least one alignment mark (1') for providing a position measurement in a second direction being different from the first direction, both directions defining the wafer plane, comprising the steps:
(a) select the first structured layer (10) and said at least one alignment mark (1) for providing a position measurement in a first direction therein,
(b) record a first photoelectric signal (3) of the alignment mark (1) of the first structured layer (10) as a function of position in said first direction,
(c) correlate the first signal with a first template signal (4) and determine the position in said first direction,
(d) select the second structured layer (11) and said at least one alignment mark (1') for providing a position measurement in a second direction being different from the first direction,
(e) record a photoelectric signal (3') of the alignment mark (1') of the second structured layer (11) as a function of position in said second direction,
(f) correlate said second signal with a second template signal (4') and determine the position in said second direction,
(g) adjust a wafer stage holding the semiconductor wafer (2) in response to the position measurement in both directions.

2. Method according to claim 1,
**characterized in that**
said first signal (3) is processed using a first filter (5) prior to being correlated with a first template signal (4), and said second signal (3') is processed using a second filter (5') prior to being correlated with a second template signal (4').

3. Method according to claim 2,
**characterized in that**
the first and second filter (5, 5') comprise at least one of smoothing, contrast amplification (9), slice level adjustment (8) or resolution modification.

4. Method according to anyone of claims 1 to 3,
**characterized in that**
the first template signal (4) is privided by a first reference signal (6), which is the photoelectric signal recorded from a first reference mark provided by a projection system of said exposure tool, and the second template signal (4') is provided by a second reference signal (6'), which is the photoelectric signal recorded from a second reference mark provided by said projection system of said exposure tool.

5. Method according to anyone of claims 1 to 4,
**characterized in that**
a laser scanning system comprising a photodiode, a photomultiplier or the like, or a CCD video camera are used to record the photoelectric signal (3, 3').

6. Method according to anyone of claims 1 to 5,
**characterized in that**
steps (a) to (f) are repeated for at least a second time using another pair of alignment marks (1, 1'), after which step (g) is performed.

7. Method according to anyone of claims 1 to 6,
**characterized in that**
said semiconductor wafer (2) contains memory chips, and said first layer (10) corresponds to a structuring layer provided to form capacitors, and said second layer (11) corresponds to a structuring layer provided to form transistors.

8. Method according to anyone of claims 1 to 7,
**characterized by**
said semiconductor wafer (2) having a diameter of at least 300 millimeters.
